# EUROPÄISCHE PATENTSCHRIFT

(11) **EP 0 762 499 B1**
(45) Veröffentlichungstag und Bekanntmachung des Hinweises auf die Patenterteilung: **11.04.2001**
(21) Anmeldenummer: 96113669.4
(22) Anmeldetag: 27.08.1996
(51) Int. Cl.: H01L 27/06, H01L 21/8252, H01L 29/868

(54) **Monolithisch integrierte Anordnung von PIN-Diode und Feldeffekttransistor und Verfahren zu deren Herstellung**
Monolithic integrated device of PIN diode and field effect transistor and method of manufacturing the same
Dispositif intégré monolithique de diode PIN et transistor à effet de champ et méthode de fabrication

(30) Priorität: 08.09.1995 DE 19533204
(43) Veröffentlichungstag der Anmeldung: 12.03.1997
(73) Patentinhaber: DaimlerChrysler AG, 70567 Stuttgart (DE)
(72) Erfinder: Brugger, Hans, Dr., 89250 Senden (DE)
(74) Vertreter: Fröhling, Werner Otto, Dr.

(56) Entgegenhaltungen:
- EP-A- 0 505 942
- WO-A-92/15113
- US-A- 5 411 914
- IEEE MTT-S INTERNATIONAL MICROWAVE SYMPOSIUM DIGEST, ORLANDO, MAY 16 - 20, 1995, Bd. 3, 16.Mai 1995, KIRBY L (ED ), Seiten 1631-1634, XP000553005 KLAASSEN A ET AL: "77 GHZ MONOLITYHIC MMIC SCHOTTKY- AND PIN-DIODE SWITCHES BASED ON GAAS MESFET AND SILICON SIMMWIC TECHNOLOGY"

## Beschreibung

Die Erfindung betrifft eine monolithisch integrierte Anordnung aus PIN-Diode und Feldeffekttransistor und ein Verfahren zu deren Herstellung.

In Kommunikations-, Sensorik- und Radarsystemen, sowie in der Radar- und Satellitentechnik werden bipolare PIN-Dioden und Feldeffekttransistoren (FET) in Form von Metall-Halbleiter-FETs (MESFETs) oder, mit zunehmend weiterer Erhöhung der Arbeitsfrequenzen in den Millimeterwellenbereich, auch neuartige Heterostruktur-FETs (HFETs) mit einem zweidimensionalen Elektronengaskanal (2DEG) eingesetzt. PIN-Dioden werden für schnelle Schalteranwendungen zur Strahlsteuerung eingesetzt und als gesteuerte Hochfrequenz (HF) Dämpfungsglieder verwendet. Ferner dienen PIN-Elemente als schnelle Begrenzer-/Schutzdioden für empfindliche Empfängerschaltkreise, um die rauscharmen Vorverstärker vor hohen Hochfrequenz (HF) Signalen zu schützen. FETs finden eine breite Anwendung als aktive Elemente zur HF-Signalerzeugung in Oszillatoren (z.B. als VCO), als rauscharmer Verstärker, als Leistungsverstärker und als aktive Mischer mit Konversionsgewinn. Für Schalteranwendungen sind jedoch FET-Bauelemente wegen der großen Einfügungsdämpfung und dem begrenzten Isolationsverhalten den PIN-Dioden deutlich unterlegen. Einer monolithischen Integration der beiden Schlüsselbauelemente PIN-Diode/MESFET und PIN-Diode/HEFT kommt deshalb besondere Bedeutung.

Mit einer monolithisch integrierten Bauelementanordnung lassen sich die für ein HF-Frontend erforderlichen Chips reduzieren und die Funktionalität eines Millimeterwellen-ICs (MMIC) vorteilhafterweise erhöhen. Dies führt zu einer insgesamt wirtschaftlicheren Gesamtlösung eines HF-Frontends, da der Aufwand an hybrider Montage- und Aufbautechnik reduziert wird und die Herstellungskosten gesenkt werden können. Ferner werden parasitäre Verluste, insbesondere an den Schnittstellen hybrider Komponenten, minimiert und dadurch die für das System erforderliche HF-Leistung vorteilhafterweise reduziert.

Für die technologische Fertigung von elektronischen Bauelementen für hohe Arbeitsfrequenzen (HF-Bauelemente) werden Halbleiterausgangsmaterialien verwendet, die mit epitaktischen Wachstumsmethoden (z.B. Molekularstrahlepitaxie, MBE, Metallorganische Gasphasenepitaxie, MOCVD) hergestellt werden. Durch die Epitaxie werden auf einem Substrat unterschiedliche, die Funktion des Bauelements bestimmende Schichten, abgeschieden und mit lithographischen Verfahren (Photo- und Elektronenstrahllithographie) und mit Ätzprozeßen (naß- und trockenchemische Verfahren) strukturiert.

Aus einer Veröffentlichung von P. Huang et al. in IEEE MTT-S Digest 1995, S. 205-206 ist eine integrierte Anordnung von GaAs HFETs mit GaAs PIN-Dioden bekannt, die eine nicht-planare Struktur mit einer hohen, vertikalen PIN-Diode (Mesastruktur) aufweist. Der HFET wird durch einen zusätzlichen Epitaxieprozeß in Form eines selektiven Wachstums hergestellt und ist in einem Bereich lokalisiert, an dem zuvor die PIN-Schichtenfolge entfernt wurde. Der insgesamte Aufwand für die Scheibenherstellung und Prozeßtechnologie ist sehr zeitintensiv und teuer. Außerdem ist für die elektrische Kontaktierung der nicht planaren Struktur eine Luftbrückentechnologie notwendig.

Der Erfindung liegt die Aufgabe zugrunde, einen integrierten Schaltkreis für den Millimeterwellenbereich und ein Verfahren zu deren Herstellung anzugeben, dessen Anordnung der Halbleiterbauelemente eine vereinfachte technische Herstellung ermöglicht. Die Aufgabe wird gelöst durch die im kennzeichnenden Teil der Patentansprüche 1, 3 und 5 angegebenen Merkmale. Vorteilhafte Ausgestaltungen und/oder Weiterbildungen sind den Unteransprüchen zu entnehmen.

Ein Vorteil der Erfindung besteht in der Kombination von MESFET und PIN-Diode bzw. HFET und PIN-Diode in integrierter Bauweise, da dadurch parasitäre Verluste, insbesondere an den Verbindungsstellen der Bauelemente, minimiert werden. Durch den erfindungsgemäßen Schichtaufbau für den integrierten Schaltkreis lassen sich die Diode und der Transistor unabhängig voneinander auf die gewünschten Eigenschaften optimieren.

Weiterhin ist vorteilhaft, daß für die Realisierung der PIN-Diode eine epitaktisch hergestellte und somit extrem reine GaAs-Schicht mit geringer Hintergrunddotierung verwendet wird, die sich unterhalb des stromführenden Kanals im Transistor befindet.

Außerdem ist vorteilhaft, daß die Schichtenfolge für den FET mit einer geringen Schichtdicke ausgelegt wird und somit eine quasi-planare Anordnung von Diode und Transistor eine vereinfachte und teilweise parallele Herstellung der Kontaktbereiche für beide Bauelemente in technologisch kompatibler Weise ermöglicht.

Weitere Vorteile bestehen darin, daß zwischen FET und Diode geeignete Ätzstop- und Schutzschichten für das selektive Entfernen der FET-Schichtenfolgen verwendet werden und, daß ein low-temperature-grown (LTG) GaAs als Pufferschicht in der FET-Schichtenfolge eingebaut wird. Damit werden Backgating- und Kurzkanaleffekte in vorteilhafterweise reduziert und insbesondere das Hochfrequenzverhalten für Leistungsanwendungen verbessert. Außerdem wird die Photoempfindlichkeit, bedingt durch Störstellenkontamination an der Grenzfläche zwischen den Schichten 4 und 9 vermindert, die, bedingt durch den ex-situ Technologieschritt vorhanden ist, z.B. in Form von Sauerstoff, Kohlenstoff, Silizium, etc.

Als Transistorbauelemente kommen MESFETs auf GaAs-Basis mit einem für den jeweiligen Einsatz optimierten Dotierstoffprofil in Frage. Ferner kommen als Transistorbauelemente HFETs auf GaAs-Substraten in Form von gitterangepaßten, einseitig oder doppelseitig dotierten Heterostrukturen mit einem zweidimensionalen Elektronengas in Frage. Als Heterostrukturen werden beispielsweise GaAs/AlGaAs-InGaAs/AlGaAs/GaAs-, InGaAs/InGaP- oder InGaAs/AlGaAs/InGaP-Materialkombinationen verwendet.

Mit der vorgeschlagenen Technologie lassen sich HFET-Bauelemente mit Grenzfrequenzen deutlich über 200 GHz und PIN-Dioden für hohe HF-Signalleistungen mit Schaltzeiten im Nanosekunden-Bereich realisieren. Mit dem vorgeschlagenen Verfahren und der vorteilhaften, monolithischen Bauelementanordnung lassen sich HF-Komponenten mit unterschiedlichen Funktionseinheiten monolithisch integrieren und dadurch die Chipzahl der HF-Frontends in vorteilhafterweise reduzieren. Beispielsweise ist eine Kombination aus FET für die HF-Leistungserzeugung und -verstärkung, sowie ein empfindlicher Signalempfänger mit rauscharmen FET-Vorverstärker und aktivem FET-Mischer, kombinierbar mit PIN-Dioden für die Strahlsteuerung innerhalb eines T/R-Moduls (Sende-/Empfangspfadumschaltung) und für die Strahlsteuerung zu verschiedenen Antennenausgängen und - eingängen realisierbar.

Die Erfindung wird anhand eines Ausführungsbeispiels und unter Bezugnahme auf schematische Zeichnungen näher erläutert.

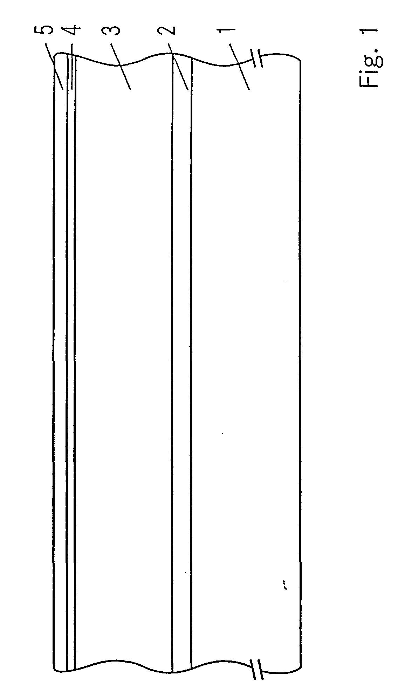

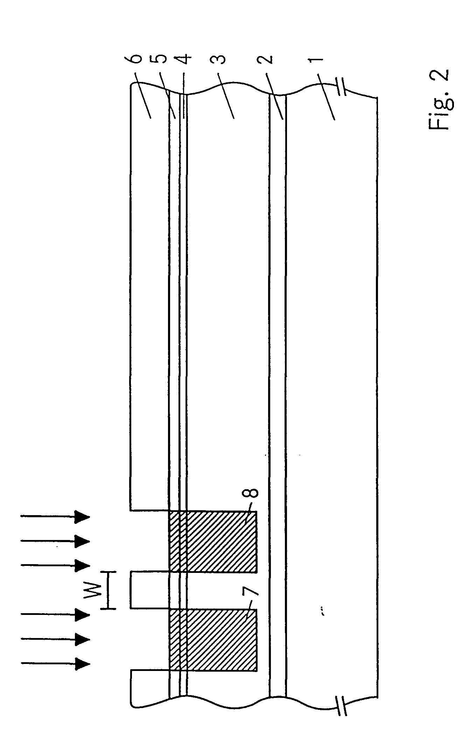

In Fig. 1 ist der Halbleiterschichtaufbau für die integrierte Bauelementanordnung dargestellt. Als Substrat wird eine halbisolierende GaAs-Scheibe 1 verwendet. Mit Hilfe einer Epitaxiemethode, vorzugsweise Molekularstrahlepitaxie (MBE), wird zuerst eine Pufferschicht 2 aus undotiertem GaAs-Material und undotiertem AlGaAs/GaAs-Übergitter hergestellt. Danach wird eine undotierte GaAs-Schicht 3 für das PIN-Diodenbauelement mit einer beispielhaften Dicke im Bereich zwischen 0,4 µm und 0,8 µm abgeschieden.

Danach wird eine dünne undotierte Schicht 4 abgeschieden, vorzugsweise aus AlAs oder AlGaAs, die als Ätzstoppschicht für die technologische Herstellung, als Desorptionsstoppschicht für die Epitaxie und als rückseitige Diffusionsbarrierenschicht für eine LTG-Schicht wirkt. Die Schicht 4 besitzt beispielsweise eine Schichtdicke im Bereich zwischen 5 nm und 50 nm. Die Oberfläche wird abschließend mit einer dünnen, undotierten GaAs-Schicht 5 passiviert, beispielsweise mit einer Schichtdicke von 50 nm.

Die Halbleiterscheibe wird in einem weiteren Technologieschritt mit einer Schicht 6, vorzugsweise einer dielektrischen Schicht, beispielsweise Si₃N₄ oder SiO₂, versehen. Mit einem photolithographischen Verfahren werden Fenster geöffnet, deren laterale Position die N- und P-Kontaktbereiche 7, 8 der PIN-Diode definieren. Die hergestellte Maske dient als Implantationsmaske für eine selektive Dotierimplantation mit donatorartigen Ionen zur Realisierung der N-Kontaktbereiche 8. Für die Realisierung der P-Kontaktbereiche 7 wird der Prozeß wiederholt.

Als Ionen für die N-Bereiche verwendet man beispielsweise Siliziumionen (Si⁺) mit einer beispielhaften Gesamtdosis von 2x10¹⁴ cm⁻² mit typischerweise 320 keV (1,5x10¹⁴ cm⁻²), 120 keV (4x10¹³cm⁻²) und 40 keV (1,5x10¹³ cm⁻²). Als Ionen für die P-Bereiche verwendet man beispielsweise Magnesiumionen (Mg⁺) mit einer beispielhaften Gesamtdosis von über 10¹⁵cm⁻². Die Energieabstufungen und relativen Dosisverhältnisse sind ähnlich wie bei der Si-Implantation, da die Atommassen der beiden Elemente ähnlich sind. Die erreichbaren Ladungsträgerdichten liegen im Bereich zwischen 1x10¹⁸ cm⁻³ und 5x10¹⁸ cm⁻³ für die N-Bereiche und zwischen 1x10¹⁹cm⁻³ und 1x10²⁰cm⁻³ für die P-Bereiche.

Generell sind andere Ionensorten für die P- und N-Kontaktbereiche verwendbar, etwa Be, C, S, Se, etc. Die Energien und die relativen Dosisverhältnisse sind dann so aufeinander abgestimmt, daß die Tiefenprofile der P- und N-Ionenverteilung möglichst gleich sind. Durch höhere Ionenenergien und Ionendosen läßt sich die Tiefe der Kontaktbereiche insgesamt vergrößern und die Leitfähigkeit erhöhen, um den Serienwiderstand der PIN-Diode zu erniedrigen. Der Abstand zwischen dem P-Kontaktbereich und dem N-Kontaktbereich definiert die Weite W der I-Schicht der PIN-Diode, die die Sperrspannung und somit die Leistungsverträglichkeit des Bauelements bestimmt.

In einem weiteren Schritt wird die Halbleiterscheibe mit einer dielektrischen Schicht versehen, beispielsweise SiON oder SiO₂, und ein Kurzzeitausheilschritt bei Temperaturen, beispielsweise im Bereich zwischen 800°C und 1000°C durchgeführt. Alternativ können die Ausheilschritte für die einzelnen Kontaktbereiche 7 und 8 getrennt nach der jeweiligen Implantation bei den jeweils optimalen Temperaturen durchgeführt werden, beispielsweise zuerst die Siliziumimplantation, danach Ausheilung des N-Kontaktbereichs 8 in einem Bereich zwischen 900°C und 1000°C und danach beispielsweise die Magnesiumimplantation und Ausheilung der P-Kontaktbereiche 7 bei einer Temperatur im Bereich zwischen 700°C und 800°C. Es ist auch möglich, die Ausheilung in-situ innerhalb der Epitaxie-Anlage unter Arsendruck durchzuführen, soweit nicht zu hohe Temperaturen notwendig sind. Dies spart insgesamt einige ex-situ Technologieschritte ein.

In einem weiteren Schritt wird die Scheibe innerhalb der Epitaxieanlage auf eine Desorptionstemperatur, vorzugsweise über der Epitaxietemperatur aber unterhalb der Oberflächendegradationstemperatur, gefahren und die natürliche Oxidschicht und die Passivierungsschicht unter Arsendruck thermisch abgetragen, z.B. im Bereich zwischen 650°C und 750°C. Dadurch wird in-situ eine mikroskopisch glatte Oberfläche der Schicht 4 für den 2. Epitaxieschritt freigelegt. Alternativ zur thermischen Desorption von Schicht 5 kann durch ein in-situ Ätzverfahren die Schicht 5 materialselektiv abgetragen werden, z.B. mit AsBr₃ oder AsCl₃. Das in-situ Ätzen hat den Vorteil, daß die Scheibe nie höher als auf die Epitaxietemperatur hochgefahren werden muß.

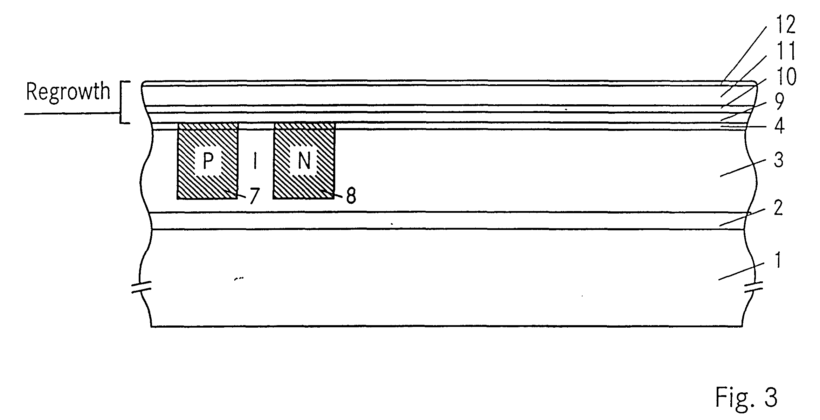

In einem weiteren Schritt wird eine weitere Schichtenfolge in Form eines sog. epitaktischen Überwachstumsprozeß, Regrowth, abgeschieden, wie in Fig. 3 dargestellt. Dies geschieht vorzugsweise in Form einer undotierten GaAs-Pufferschicht, einer Diffusionsbarrierenschicht und einer Schichtenfolge für einen FET in Form einer HFET-oder MESFET-Schichtenfolge.

Die Regrowth-Schichtenfolge besteht beispielsweise aus
- einer undotierten LTG-Pufferschicht 9 aus GaAs, mit einer Dicke von typischerweise zwischen 10 nm und 100 nm, abgeschieden bei tiefer Substrattemperatur im Bereich zwischen 200°C und 300°C und unter Arsenanreicherung, im Bereich von einigen Prozent Arsenüberschuß
- einer Diffusionsbarrierenschicht 10 aus AlAs, AlGaAs, oder GaInP mit einer beispielhaften Dicke zwischen 5 nm und 20 nm, die bei einer Substrattemperatur zwischen 500^{o}C und 700°C abgeschieden wird
- einer FET-Schichtenfolge 11
- einer n-dotierten GaAs-Deckschicht 12 mit einer Dotierkonzentration von 5x10¹⁸cm⁻³ und einer Schichtdicke von 40 nm, die bei einer Substrattemperatur zwischen 500°C und 700°C abgeschieden wird.
Die Schichtenfolge 11 besteht für ein HFET-Bauelement beispielsweise aus
- einer dünnen GaAs-Schicht von 10 nm bis 50 nm Schichtdicke, einer undotierten InGaAs-Schicht mit einem Indiumgehalt von ca. 20% von 10 nm bis 20 nm Schichtdicke, einer undotierten GaAs/AlGaAs-Heterostruktur Spacerschicht mit einem Al-gehalt von 25% von 2 nm bis 5 nm Schichtdicke,
- einer n-Typ modulationsdotierten AlGaAs-Schicht mit einer homogenen, oder einer pulsförmigen oder deltaförmigen n-Dotierung von 30 nm Schichtdicke.
Die Schichtenfolge 11 besteht für ein MESFET-Bauelement, beispielsweise aus
- einer dünnen, undotierten GaAs-Schicht von 10 nm bis 50 nm Schichtdicke,
- einer n-dotierten GaAs-Schicht mit einer Dotierkonzentration von 3x10¹⁷ cm⁻³ und einer Schichtdicke von 150 nm.
- Beide Schichten werden bei einer Substrattemperatur zwischen 500°C und 700°C abgeschieden.

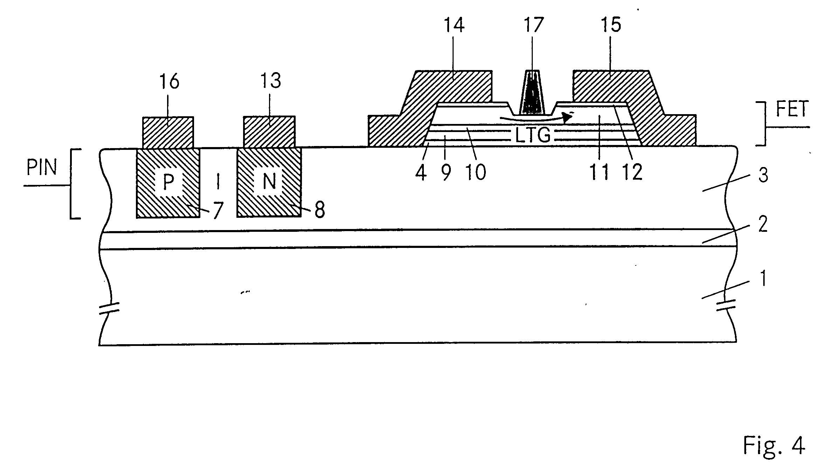

Für die Bauelementherstellung werden an den Stellen, die für das PIN-Bauelement vorgesehen sind, die GaAs-Deckschicht 12, die FET-Schichtenfolge 11, die Diffusionsbarrierenschicht 10 und die LTG-Schicht 9 mit photolithographischen Verfahren und einem selektiven Ätzprozeß entfernt, der an der Oberfläche der Schicht 4 stoppt, wie in Fig. 4 dargestellt. Anschließend wird ein selektiver Ätzprozeß verwendet, der die Schicht 4 abträgt und an der GaAs-Oberfläche der PIN-Schicht 3 stoppt.

Die Kontaktmetallisierungen werden durch Einsatz von photolithographischen Verfahren und konventionellen Aufdampftechniken hergestellt. Dies ist schematisch in Fig. 4 dargestellt. Dabei werden die ohmschen Kontakte 13 für die N-leitenden Kontaktbereiche 8 der PIN-Diode zusammen mit den ohmschen Source- und Drain- Kontakten 14,15 des FET-Bauelements hergestellt, beispielsweise mit einer Metallisierungsschichtenfolge Ge/Ni/Au. Der ohmsche P-Kontakt 16 der PIN-Diode wird entsprechend hergestellt, beispielsweise mit einer Metallisierungsschichtenfolge Ti/Pt/Au. Durch einen Kurzzeitausheilschritt, beispielsweise bei ca. 400°C erfolgt die Legierung sämtlicher ohmscher Kontakte der Bauelementanordnung. Der FET Gate-Schottkykontakt 17 wird mit Hilfe einer lithographischen Technik definiert (z.B. mit Stepperverfahren) oder bei sehr kleinen Gatedimensionen durch den Einsatz einer Elektronenstrahllithographie realisiert.

Die Erfindung ist nicht auf die im Ausführungsbeispiel angegebene Schichtfolge begrenzt, sondern alternativ kann die Schicht 9 nicht als LTG-Schicht ausgelegt sein, d.h. die Abscheidung erfolgt ebenfalls bei der üblichen Epitaxietemperatur. Außerdem kann die Diffusionsbarrierenschicht 10 weggelassen werden. Ferner kann die FET-Schichtenfolge 11 zusammen mit der AlGaAs-Schicht oder anstatt dieser eine GaInP-Schicht enthalten, die vorteilhafterweise als Ätzstoppschicht für die Gate-Kontaktherstellung 17 benutzt wird.

## Patentansprüche

1. Monolithisch integrierte Anordnung von PIN-Diode und Feldeffekttransistor, wobei
- PIN-Diode und Feldeffekttransistor aus III/V-Halbleiterverbindungen aufgebaut sind, und
- die PIN-Diode in einer undotierten, epitaktisch hergestellten Halbleiterschicht (3) aus implantierten N-und P-Kontaktbereichen (8, 7) aufgebaut ist, dadurch gekennzeichnet,
- daß der Feldeffekttransistor aus einer HFET- oder MESFET-Halbleiterschichtenfolge besteht mit einer Gesamtschichtdicke von weniger als 0,2µm, und
- daß der Feldeffekttransistor lateral zur PIN-Diode angeordnet ist, derart, daß auf der undotierten Halbleiterschicht der PIN-Diode im Bereich des Transistors eine Ätzstopschicht aus undotiertem III/V-Halbleitermaterial vorhanden ist, auf der der Feldeffekttransistor aufgebracht ist.

2. Monolitisch integrierte Anordnung nach Anspruch 1, dadurch gekennzeichnet, daß die Halbleiterschichtenfolge des Feldeffekttransistors eine LTG-Schicht (9) und eine Diffusionsbarrierenschicht (10) enthält.

3. Verfahren zur Herstellung der Schichtenfolge einer Anordnung nach den vorherigen Ansprüchen, dadurch gekennzeichnet, daß in einem ersten Epitaxieverfahren
- auf einem halbisolierenden GaAs-Substrat (1) eine erste Pufferschicht (2) aus undotiertem GaAs und einem AlGaAs/GaAs-Übergitter mit einer Gesamtschichtdicke von 0,2 µm, eine undotierte GaAs-Schicht (3) mit einer Schichtdicke zwischen 0,4 µm und 0,8 µm, eine Ätzstoppschicht (4) aus undotiertem AlAs oder AlGaAs mit einer Schichtdicke von 5 nm bis 50 nm und eine Passivierungsschicht (5) aus GaAs mit einer Schichtdicke von 50 nm abgeschieden werden,
- anschließend eine dielektrische Schicht (6) aufgebracht und derart strukturiert wird, daß eine Implantationsmaske hergestellt wird, mit der in einem nachfolgenden Implantationschritt die N- und P-Kontaktbereiche (7, 8) für die PIN-Diode in der undotierten GaAs-Schicht (3) hergestellt werden,
- nach einem Ausheilschritt für die implantierten Bereiche (7, 8) die dielektrische Schicht (6) entfernt wird,
- in einem thermischen Desorptionsprozeß unter Arsendruck oder durch materialselektives Ätzen mit AsBr₃ oder AsCl₃ die Passivierungsschicht (5) entfernt wird,
und daß in einem zweiten Epitaxie-Verfahren eine Regrowth-Schichtenfolge hergestellt wird aus
- einer undotierten LTG-Schicht (9) aus GaAs mit einer Schichtdicke-zwischen 10 nm und 100 nm,
- einer Diffusionsbarrierenschicht (10) aus undotiertem AlAs oder AlGaAs oder GaInP mit einer Schichtdicke zwischen 5 nm und 20 nm,
- einer HFET oder MESFET-Schichtenfolge (11) mit einer Gesamtschichtdicke von weniger als 0,2 *µ*m und
- einer n-dotierten GaAs-Deckschicht (12) mit einer Dotierkonzentration von 5x10¹⁸ cm⁻³ und einer Schichtdicke von 40 nm.

4. Verfahren nach Anspruch 3, dadurch gekennzeichnet, daß die LTG-Schicht (9) mit einem Arsenüberschuß von 1% bis 3% angereichert wird und bei eines Substrattemperatur von 200°C bis 300°C gewachsen wird.

5. Verfahren zur Herstellung einer Anordnung nach den Ansprüchen 1 und 2 mit einer Schichtenfolge nach Anspruch 3, dadurch gekennzeichnet,
- daß im Bereich der PIN-Diode die Deckschicht (12), die Schichtenfolge (11) des Feldeffekttransistors, die Diffusionsbarrierenschicht (10) und die LTG-Schicht (9) selektiv weggeätzt werden,
- daß anschließend die Ätzstopschicht (4) entfernt wird, und
- daß die Kontakte für PIN-Diode und Feldeffekttransistor hergestellt werden.

6. Verfahren nach Anspruch 5, dadurch gekennzeichnet, daß die ohmschen Kontakte (13) der PIN-Diode und die ohmschen Source- und Drainkontakte (14,15) des Feldeffekttransistors in einem Metallisierungsschritt hergestellt werden.

## Claims

1. Monolithic integrated arrangement of PIN diode and field effect transistor, wherein
- PIN diode and field effect transistor are built up from III/V semiconductor compounds, and
- the PIN diode is built up in an undoped, epitaxially produced semiconductor layer (3) of implanted N and P contact regions (8, 7),
characterised in that
- the field effect transistor consists of an HFET or a MESFET semiconductor layer sequence with a total layer thickness of less than 0.2 microns, and
- the field effect transistor is arranged laterally relative to the PIN diode in such a manner that an etching stop layer of undoped III/V semiconductor material, on which the field effect transistor is situated, is present on the undoped semiconductor layer of the PIN diode in the region of the transistor.

2. Monolithic integrated arrangement according to claim 1, characterised in that the semiconductor layer sequence of the field effect transistor comprises an LTG layer (9) and a diffusion barrier layer (10).

3. Method of producing the layer sequence of an arrangement according to the preceding claims, characterised in that in a first epitaxial process
- a first buffer layer (2) of an undoped GaAs and an AIGaAs/GaAs superlattice with a total layer thickness of 0.2 microns, an undoped GaAs layer (3) with a layer thickness between 0.4 microns and 0.8 microns, an etching stop layer (4) of undoped AlAs or AlGaAs with a layer thickness of 5 nm to 50 nm and a passivating layer (5) of GaAs with a layer thickness of 50 nm are precipitated on a semiinsulating GaAs substrate (1),
- subsequently a dielectric layer (6) is applied and structured in such a manner that an implantation mask is produced by which in a following implantation step the N and P contact regions (7, 8) for the PIN diode are produced in the undoped GaAs layer (3),
- the dielectric layer (6) is removed after a curing step for the implanted regions (7, 8), and
- the passivating layer (5) is removed in a thermal desorption process under arsenic pressure or by material-selective etching with AsBr₃ or AsCl₃,
and that in a second epitaxial method a regrowth layer sequence is produced from
- an undoped LTG layer (9) of GaAs with a layer thickness between 10 nm and 100 nm,
- a diffusion barrier layer (10) of undoped AlAs or AlGaAs or GalnP with a layer thickness between 5 nm and 20 nm,
- an HFET or a MESFET layer sequence (11) with a total layer thickness of less than 0.2 microns and
- an n-doped GaAs cover layer (12) with a doping concentration of 5 x 10¹⁸ cm⁻³ and a layer thickness of 40 nm.

4. Method according to claim 3, characterised in that the LTG layer (9) is enriched with an arsenic excess of 1% to 3% and is grown at a substrate temperature of 200°C to 300°C.

5. Method for the production of an arrangement according to claims 1 and 2 with a layer sequence according to claim 3, characterised in that
- the layer sequence (11) of the field effect transistor, the diffusion barrier layer (10) and the LTG layer (9) are selectively etched away in the region of the PIN diode,
- subsequently the etching stop layer (4) is removed, and
- the contacts for PIN diode and field effect transistor are produced.

6. Method according to claim 5, characterised in that the resistive contacts (13) of the PIN diode and the resistive source and drain contacts (14, 15) of the field effect transistor are produced in a metallisation step.

## Revendications

1. Dispositif intégré de façon monolithique comprenant une diode PIN et un transistor à effet de champ, et dans lequel
- la diode PIN et le transistor à effet de champ sont constitués par des composés semiconducteurs III/V, et
- la diode PIN et formée dans une couche semiconductrice (3) non dopée, fabriquée par épitaxie, à partir de zones de contact implantées de type N et P (8, 7),
caractérisé en ce
- que le transistor à effet de champ est constitué par une suite de couches semiconductrices de HFET ou MESFET, avec une épaisseur totale des couches inférieures à 0,2 µm, et
- que le transistor à effet de champ est disposé latéralement par rapport à la diode PIN, de telle sorte que dans la couche semiconductrice non dopée de la diode PIN est présente, dans la zone du transistor, une couche d'arrêt d'attaque chimique formée d'un matériau semiconducteur III/V non dopé, et sur laquelle est disposé le transistor à effet de champ.

2. Dispositif intégré de façon monolithique selon la revendication 1, caractérisé en ce que la suite de couches semiconductrices du transistor à effet de champ contient une couche LTG (9) et une couche (10) formant barrière contre la diffusion (10).

3. Procédé pour fabriquer la suite de couches d'un dispositif selon les revendications précédentes, caractérisé en ce que dans un premier procédé d'épitaxie
- on dépose sur un substrat en GaAs semi-isolant (1) une première couche (2) formée de GaAs non dopée et d'un réseau recouvrant formé de AlGaAs/GaAs possédant une épaisseur totale de couche de 0,2 µm, une couche en GaAs non dopée (3) ayant une épaisseur comprise entre 0,4 µm et 0,8 µm, une couche (4) d'arrêt contre la corrosion formée de AlAs ou de AlGaAs, non dopée, ayant une épaisseur comprise entre 5 nm et 50 nm, une couche de passivation (5) formée de GaAs ayant une épaisseur égale à 50 nm,
- puis on dépose une couche diélectrique (6) et on la structure de manière à former un masque d'implantation, à l'aide duquel on forme, lors d'une étape suivante d'implantation, les zones de contact de type N et P (7, 8) pour la diode PIN dans la couche en GaAs non dopée (3),
- après une étape de recuit pour les zones implantées (7, 8), on élimine la couche diélectrique (6),
- lors d'un processus de désorption thermique on élimine la couche de passivation (5) sous une pression d'arsenic ou bien au moyen d'une corrosion, sélective du point de vue du matériau, avec du AsBr₃ et du AsCl₃, et
que dans un second procédé d'épitaxie, on réalise une suite de couches de recroissance constituée par:
- une couche de LTG non dopée (9) formée de GaAs et possédant une épaisseur comprise entre 10 nm et 100 nm,
- une couche (10) formant barrière contre la diffusion formée de AlAs ou de AlGaAs ou de GaInP, non dopée, possédant une épaisseur comprise entre 5 nm et 20 nm,
- une succession (11) de couches de HFET ou MESFET possédant une épaisseur totale inférieure à 0,2 µm, et
- une couche de recouvrement GaAs dopée de type n (12) possédant une concentration de dopage égale à 5x10¹⁸ cm⁻³ et une épaisseur de 40 nm.

4. Procédé selon la revendication 3, caractérisé en ce qu'on enrichit la couche de LTG (9) avec un excès d'arsenic compris entre 1 % et 3 % et on la fait croître pour une température du substrat comprise entre 200°C et 300°C.

5. Procédé pour fabriquer un dispositif selon les revendications 1 et 2, possédant une succession de couches selon la revendication 3, caractérisé en ce
- qu'on élimine sélectivement par corrosion, dans la zone de la diode PIN, la couche de revêtement (12), la succession de couches (11) du transistor à effet de champ, la couche (10) formant barrière contre la diffusion et la couche de LTG (9),
- qu'on élimine ensuite la couche (4) d'arrêt contre la corrosion, et
- qu'on réalise les contacts pour la diode PIN et le transistor à effet de champ.

6. Procédé selon la revendication 5, caractérisé en ce qu'on réalise les contacts ohmiques (13) de la diode PIN et les contacts ohmiques de source et de drain (14, 15) du transistor à effet de champ lors d'une étape de métallisation.
